# EUROPEAN PATENT APPLICATION

(11) **EP 4 394 463 A1**
(43) Date of publication of application: **03.07.2024**
(21) Application number: 23162920.5
(22) Date of filing: 20.03.2023
(51) Int. Cl.: G02B 6/12, H01L 25/16

(54) **SEMICONDUCTOR STRUCTURE AND METHOD FOR FABRICATING A SEMICONDUCTOR STRUCTURE**

(30) Priority: 30.12.2022 EP 22217395
(71) Applicant: IHP GmbH - Innovations for High Performance Microelectronics / Leibniz-Institut für innovative Mikroelektronik, 15236 Frankfurt (Oder) (DE)
(72) Inventor: Lischke, Stefan, 15236 Frankfurt (Oder) (DE); Goetz, Florian, 15236 Frankfurt (Oder) (DE); Zimmermann, Lars, 15236 Frankfurt (Oder) (DE); Baristiran Kaynak, Canan, 15236 Frankfurt (Oder) (DE)
(74) Representative: Eisenführ Speiser

(57) **Abstract**

The present invention relates to a semiconductor structure comprising a semiconductor wafer and a photonic integrated circuit or an electronic-photonic integrated circuit, hereinafter commonly referred to as integrated circuit, on the semiconductor wafer. The integrated circuit comprises a front-end-of-line section, hereinafter FEOL section, and comprises a back-end-of-line section, hereinafter BEOL section, with interconnect layer pairs each comprising a metal interconnect layer and an interlevel dielectric layer. A wafer-to-wafer bonding interface between a first of the interconnect layer pairs and a second of the interconnect layer pairs is arranged closer to the FEOL section than the first interconnect layer pair or a wafer-to-wafer bonding interface is formed between the first of the interconnect layer pairs and the FEOL section. The first interconnect layer pair comprises at least one SiN waveguide.

## Description

### TECHNICAL FIELD

The present invention relates to a semiconductor structure, and in particular, to an integrated optoelectronic device. Furthermore, the present invention relates to a method for fabricating a semiconductor structure, and in particular, for fabricating an integrated optoelectronic device.

### BACKGROUND OF THE INVENTION

Electromagnetic radiation in a wavelength range of 1.3 µm to 1.55 µm is typically used for transmission of light signals in fiber-optic telecommunication systems. The infrared wavelength of 1.55 µm is particularly suited for silicon (Si)-based photonics and optoelectronic devices, which use silicon as an optical medium. However, Si-based optoelectronics is also suited for other applications in other spectral ranges from the visible to the mid infrared, in particular between 0.4 µm to 1.8 µm.

For transmission of light signals in integrated optoelectronic devices, typically, waveguides are employed that guide light signals with minimal loss of energy by restricting the transmission of energy to one direction. Fabricating waveguides from a semiconductor material is often required since semiconductor waveguides enable for monolithic integration into integrated optoelectronic devices using well established processing techniques. For example, Si-based waveguides can be fabricated in a standard Si-based fabrication process, e.g., by means of complementary metal-oxide-semiconductor (CMOS) technology.

Next to Si waveguides also the integration of silicon nitride (SiN) waveguides were investigated, e.g., in S. Lisckhe et. al, "Silicon nitride waveguide coupled 67+ GHz Ge photodiode for non-SOI PIC and ePIC platforms" 2019 IEEE International Electron Devices Meeting (IEDM)/ 2019, pp. 33.2.1-33.2.4, doi: 10.1109/IEDM19573.2019.8993651 or in Jared F. Bauters et al., "Planar waveguides with less than 0.1 dB/m propagation loss fabricated with wafer bonding", Opt. Express 19, 24090-24101 (2011). Silicon nitride waveguides show a plethora of beneficial properties in comparison to silicon-on-insulator (SOI) based waveguides such as an enhanced optical bandwidth allowing for low loss waveguides in the classic communication bands (C- and O-bands) as well as in the visible wavelength range were Si waveguides have already become opaque. Moreover, since SiN does not exhibit two-photon absorption, optical power handling can be superior compared to that in Si waveguides.

However, to date, it remains challenging to provide monolithically integrated high speed modulators or SiN waveguides coupled to detectors in SiN-based photonic integrated circuit (PIC) platforms.

### SUMMARY OF THE INVENTION

The present invention is based on the objective of providing a semiconductor structure, and in particular, an integrated optoelectronic device, comprising a photonic integrated circuit or an electronic-photonic integrated circuit and at least one SiN waveguide in the backend-of-line (BEOL). In particular, the at least one SiN waveguide should be an ultra-low loss SiN waveguide, in particular, in the wavelength range of 0.4 µm to 1.8 µm. The present invention is based on the further objective of providing a method of fabricating a semiconductor structure, in particular, an integrated optoelectronic device, comprising a photonic integrated circuit or an electronic-photonic integrated circuit and at least one SiN waveguide in the BEOL. The method should, in particular, enable an integration of ultra-low loss SiN waveguide in the BEOL of standard Si technologies.

According to the invention, a semiconductor structure and in particular, an integrated optoelectronic device is proposed. The semiconductor structure comprises a semiconductor wafer and a photonic integrated circuit or an electronic-photonic integrated circuit, hereinafter commonly referred to as integrated circuit, on the semiconductor wafer. The integrated circuit comprises a front-end-of-line section, hereinafter FEOL section, and comprises a back-end-of-line section, hereinafter BEOL section. The BEOL section comprises interconnect layer pairs each comprising a metal interconnect layer and an interlevel dielectric layer. Moreover, a wafer-to-wafer bonding interface is formed between a first of the interconnect layer pairs and a second of the interconnect layer pairs, the second of the interconnect layer pairs is arranged closer to the FEOL section than the first interconnect layer pair. Alternatively, a wafer-to-wafer bonding interface is formed between the first of the interconnect layer pairs and the FEOL section. Furthermore, the first interconnect layer pair comprises at least one SiN waveguide.

The invention includes the recognition that in the wavelength region generally used in optical telecommunication, i.e., in the C-band at 1.55 µm, low loss SiN waveguides typically need to be fabricated at temperatures of 600 °C or higher. For example, such low loss SiN waveguides may require low pressure chemical vapour deposition (LPCVD) materials which are deposited at temperatures well above 700 °C. However, these comparatively high temperatures are generally incompatible to standard BEOL processes and LPCVD is merely used in a FOEL process.

However, it was found that when using wafer-bonding techniques, it is possible to integrate LPCVD materials even in the BEOL of an integrated optoelectronic device. This is possible since one or more LPCVD layers can be deposited on a separate, second wafer (herein called "bonding wafer") such that single or even multiple LPCVD SiN layers could be realized. From these one or more SiN layers, SiN waveguides with low-, moderate- and high-optical confinement can be realized. With this approach, any thermal treatment required for further loss reduction can be performed on the separate bonding wafer before wafer-to-wafer bonding, such that there is no impact on the host semiconductor wafer that comprises the FEOL section of the integrated circuit.

The wafer-to-wafer bonding results in a bonding interface in the BEOL section between a first of the interconnect layer pairs and a second of the interconnect layer pairs. In case the wafer-to-wafer bonding interface is formed between the first of the interconnect layer pairs and the FEOL section, the semiconductor structure has a bonding interface at the transition from the FEOL section and the BEOL section. For example, the FEOL can be fabricated up to a first contact module, e.g., a first tungsten contact module, because at this level the semiconductor wafer offers a planar and smooth surface, well suited for wafer-to-wafer bonding. To this planar and smooth surface, the first of the interconnect layer pairs can be bonded resulting in the wafer-to-wafer bonding interface between the first of the interconnect layer pairs and the FEOL section. Moreover, the first interconnect layer pair of the BEOL section comprises at least one SiN waveguide. With the semiconductor wafer it is thus possible to provide at least one SiN waveguide in the BEOL section of an integrated circuit.

Preferably, in the FEOL section, the integrated circuit comprises several electronic, optoelectronic and/or photonic components, e.g., transistors, diodes, resistors, capacitors, photodiodes, photodetectors, optical waveguides, frequency converters and lasers. In particular, the integrated circuit may comprise one or more active and/or passive photonic components, including in particular a laser, a light detector, an optical modulator for modulating intensity, phase or polarization of light, an optical switch, an optical delay element, an optical amplifier, or an optical frequency converter. Passive components are in particular filters, splitters, combiners and isolators.

As such, the FEOL fabrication covers those processing steps, which are performed before the deposition of an interconnect stack. Thus, at the end of the FEOL processing, there is a semiconductor wafer with components that are generally not connected by wiring. The BEOL is the subsequent part of fabrication, in which an interconnect stack with interconnections between the individual components on the semiconductor wafer is fabricated, including the desired wiring in the metal planes of the interconnect stack and vias connecting wiring on different metal planes. BEOL processing thus typically begins after FEOL processing with the deposition of a first metal plane on a substrate. BEOL processing also includes the fabrication of contacts, dielectric layers, and bonding sites for chip-to-package connections. Since FEOL and BEOL processing are typically performed in different processing facilities, the strict requirements regarding avoidance of contamination of the processed wafer that apply in a FEOL processing facility, do not equally apply in BEOL processing, thus offering much larger freedom to include materials in the BEOL processing that would not be allowed for processing in a FEOL CMOS processing facility.

Accordingly, an interconnect stack of the BEOL arranged on the FEOL section of an integrated circuit comprises a plurality of metal interconnect layers that sometimes are also called metal levels, which contain structured metal connect traces and which are separated from each other by an interlevel dielectric material. Due to the way of fabricating the metal interconnect layers, they can be considered as interconnect layer pairs each comprising a metal interconnect layer and an interlevel dielectric layer. That is because the BEOL fabrication is generally performed in subsequent layers such that interconnect layer pair after interconnect layer pair is fabricated. As a result of the BEOL processing there are several metal interconnect layers electrically connected by means of vias or plugs and electrically isolated from each other by means of interlevel dielectric layers separating the metal interconnect layers.

Preferably, the semiconductor structure's semiconductor wafer is made of silicon or comprises silicon. For example, in many application cases, the most suitable semiconductor wafer is a SOI wafer. Silicon-on-Insulator is a semiconductor technology where components are fabricated in a Si layer on top of a buried insulator layer. SOI substrates are suitable in particular for applications in the near and mid infrared regions between 1.2 µm and 3 µm wavelength, which include the wavelengths used for data communication via glass fiber. An advantage of SOI technology is its compatibility with well-established CMOS fabrication processes and the associated infrastructure used in microelectronics and thus provides advantages in terms of compatibility, reproducibility and cost. However, an SOI semiconductor wafer is not required for instance, if SiN material platform is used.

Preferably, a SiN waveguide comprised by an interconnect layer pair is arranged within the interlevel dielectric layer of the respective interconnect layer pair.

It is possible that the semiconductor structure comprises at least two interconnect layer pairs that are integrated via wafer-to-wafer bonding. Each of these interconnect layer pairs that are integrated using wafer-to-wafer bonding may comprise at least one SiN waveguide. Accordingly, due to the wafer-to-wafer bonding integration process, the respective interconnect layer pairs each have a wafer-to-wafer bonding interface to a further interconnect layer pair or the FEOL section. The semiconductor structure may thus include more than one wafer-to-wafer bonding interface.

The at least one SiN waveguide may be a low confinement waveguide with a thickness of 10 nm to 100 nm, preferably, of 30 nm to 70 nm, even more preferably, of about 50 nm. Alternatively, the at least one SiN waveguide may be a moderate-confinement waveguide with a thickness of more than 100 nm and up to 600 nm, preferably, of 300 nm to 500 nm, even more preferably, of about 400 nm. Yet, alternatively, the at least one SiN waveguide may be a high-confinement waveguide with a thickness of more than 600 nm and up to 1000 nm, preferably, of 700 nm to 900 nm, even more preferably, of about 800 nm. In particular, in the semiconductor structure, several different SiN waveguides can be present, e.g., with low optical confinement realised with a SiN waveguide with a thickness of less than 100 nm and a further SiN waveguide with high optical confinement with a thickness of more than 600 nm. These several SiN waveguides can have different distances to the FEOL section.

Preferably, in the semiconductor structure, the second of the interconnect layer pairs is arranged directly on the FEOL section. Alternatively, the first interconnect layer pair may be embedded between further interconnect layer pairs of the BEOL section. Accordingly, the first interconnect layer pair can be positioned at various different distances to the integrated circuit within the BEOL section. Between the first interconnect layer pair and the integrated circuit there may be no, one or more than one further interconnect layer pair. The wafer-to-wafer bonding could thus be performed at any level in the BEOL section such that the SiN waveguides could positioned at various distances from the FEOL section. Coupling of a SiN waveguide to photonic components in the FEOL section could be performed by through backend interlayer coupling, e.g., as described in EP 4 102 272 A1, which is incorporated herein by reference in its entirety. For example, interlayer coupling may be achieved with an optical interconnect structure that extends laterally in an optical coupling region between the SiN waveguide in the BEOL section and a photonic component in the FEOL section. For the purpose of definition, the lateral extension of the optical coupling region includes lateral overlap sections of the interconnect stack that exhibit a lateral overlap of the SiN waveguide or of the photonic component in the FEOL section with the interconnect structure.

An optical interconnect structure may be arranged and configured for optically coupling electromagnetic radiation from the SiN waveguide in the BEOL section into the photonic component in the FEOL section and *vice versa.* To this end, the optical interconnect structure may comprise a vertical stack of one or more optically coupled though-backend interlayer couplers, e.g., in form of low confinement waveguide elements, made of a first dielectric material, which each are embedded in a second dielectric material, e.g., in a interlevel dielectric layer of an interconnect layer pair. The lower the confinement of the though-backend interlayer couplers, e.g., in form of waveguides, is, the less though-backend interlayer couplers are needed. It is thus preferred that in the semiconductor structure at least one interconnect layer pair includes a though-backend interlayer coupler that is arranged and configured for coupling electromagnetic radiation out of or into the at least one SiN waveguide of the first interconnect layer pair.

The first dielectric material, preferably, has an index of refraction of a higher value than the embedding second dielectric material in a desired wavelength range of operation of the semiconductor structure. The first dielectric material of the optically coupled waveguide elements may be silicon nitride, e.g., Si₃N₄, whereas the second dielectric material may be SiOz. Whereas SiOz is preferred as the embedding second dielectric material due to its predominant use as the interlevel dielectric material in BEOL technologies, the first dielectric material can be selected from a larger variety of materials. In particular, suitable materials for the first dielectric layer have an index of refraction higher than that SiOz, suitably thus in the range between 1.5 and 2.8. Examples of suitable materials for use as the first dielectric material beside silicon nitride (SiₓN_{y}) are aluminum nitride (AIN), aluminum oxide (AlₓO_{y}), in particular sapphire (Al₂O₃), aluminumoxinitride (AION) in any stoichiometry, hafnium oxide (HfOₓ), tantalum oxide TazOs, titanium oxide (TiOₓ), silicon oxinitride SiON, or zirconium oxide ZrOₓ. Unspecified stoichiometries, partly indicated by indices x and y in the above list of materials, express variability in the material design for the purpose of optimization of optical properties and ease of fabrication in a given context of desired application and fabrication technology.

Preferably, in the semiconductor structure, the first interconnect layer pair comprises at least two SiN waveguides that each being located at a different distance from the integrated circuit. The at least two SiN waveguides may be selected from at least one of a low optical confinement SiN waveguide, a moderate optical confinement SiN waveguide, and a high optical confinement SiN waveguide.

Preferably, in the semiconductor structure, the at least one SiN waveguide of the first interconnect layer pair is evanescently coupled to a further photonic component, e.g. a further photodetector or a waveguide, e.g., a SiN waveguide or a Si waveguide. The at least one SiN waveguide can be directly coupled to the further photonic component or can be indirectly coupled using an optical interconnect structure as described above. The further photonic component can be located in the first interconnect layer pair, or in the second of the interconnect layer pairs, or in a different one of the interconnect layer pairs of the BEOL section. The further photonic component may also be located in the FEOL section. For example, the further photonic component can be a further SiN waveguide that is located in the FEOL section.

The distance between the at least one SiN waveguide and the further photonic component, preferably, is 500 nm or less, e.g., 150 nm or less or even 100 nm or less, to enable the evanescent coupling of electromagnetic radiation between SiN waveguide and the further photonic component.

In the semiconductor structure it is preferred that the at least one SiN waveguide of the first interconnect layer pair is configured to guide electromagnetic radiation at a wavelength of 400 nm or more, e.g., 400 nm to 2 µm, preferably, 850 nm or more, preferably, 1 µm or more, e.g., of 1.55 µm, with a loss below or no more than 1 db per cm. An accordingly configured SiN waveguide is generally referred to as an ultra-low loss SiN waveguide. An ultra-low loss SiN waveguide can, in general, be fabricated using LPCVD at temperatures of more than 600 °C, e.g., 700 °C or more.

By the proposed bonding approach, it is possible to integrate a FEOL material that offers ultra-low losses, i.e., LPCVD silicon nitrides, in the BEOL of a semiconductor structure. In addition to the material, also substrate related losses may contribute to an overall SiN waveguide propagation loss, which is especially the case for low-confinement SiN waveguides. It was found that using a local backside etch in the semiconductor wafer may reduce or even prevent substrate losses of electromagnetic radiation guided in the SiN waveguide.

Accordingly, it is preferred that the semiconductor wafer comprises a local backside etch at a position opposite the at least one SiN waveguide of the first interconnect layer pair. A local backside etch in the semiconductor wafer opposite the at least one SiN waveguide is of particular advantage, if the SiN waveguide is a low-confinement SiN waveguide. This is because substrate losses can be further reduced and the performance of the low-confinement SiN waveguide can be further enhanced. A local backside etch in the semiconductor wafer can be realised by at least partially removing the substrate by local-backside etch of the semiconductor wafer in a certain area.

Preferably, in the semiconductor structure, the FEOL section comprises a Ge photodiode, the Ge photodiode being evanescently coupled to the at least one SiN waveguide of the first interconnect layer pair. The Ge photodiode, preferably, comprises a laterally aligned p-i-n- region. Alternatively, the Ge photodiode may be a vertical photodiode, i.e., comprising a vertically aligned p-i-n- region. Optical coupling to the FEOL integrated germanium photodiode could be performed directly from the SiN waveguide as demonstrated by S. Lisckhe et. al, in "Silicon nitride waveguide coupled 67+ GHz Ge photodiode for non-SOI PIC and ePIC platforms" 2019 IEEE International Electron Devices Meeting (IEDM)/ 2019, pp. 33.2.1-33.2.4, doi: 10.1109/IEDM19573.2019.8993651. In this case, no SOI substrate is needed.

The Ge photodiode can be configured as described in WO 2022/043513 A1 which is incorporated herein by reference in its entirety. Alternatively, the Ge photodiode can be configured as described in EP22207291.0 which is incorporated herein by reference in its entirety. Accordingly, the Ge photodiode may be a lateral photodiode and form a photodetector for detecting electromagnetic radiation in conjunction with a SiN waveguide. The lateral photodiode comprises an in-situ p-doped contact region, an in-situ n-doped contact region and, sandwiched between the p-doped contact region and n-doped contact region along a lateral stacking direction, an intrinsically doped light-sensitive region. The SiN waveguide comprises SiN and is configured to guide electromagnetic radiation along a propagation direction. The SiN waveguide is arranged on top of the lateral photodiode along a vertical stacking direction that is perpendicular to the lateral stacking direction. In the photodetector, at least a part of the light-sensitive region and at least a part of the SiN waveguide form a common upper interface at which the light-sensitive region is in direct contact with the SiN waveguide. Moreover, the light-sensitive region has a lateral width along the lateral stacking direction of 500 nm or less, preferably, of 200 nm or less, e.g., of 150 nm or less.

With the photodetector according to the invention, it is possible to combine a low loss SiN waveguide with a lateral photodiode that can be operated at an opto-electrical -3 dB bandwidth of 100 GHz or beyond, e.g., of 200 GHz or more. This is possible since the deposition of a SiN layer for fabricating the SiN waveguide can be carried out before fabricating the in-situ p-doped and n-doped contact regions. The deposition of the SiN layer is thus not limited by thermal budget constraints, as it would be the case in known device concepts. This has the advantage that dopant diffusion and deactivation effects provoked by thermal processes that both have negative effects on the opto-electrical bandwidth of the photodetector can be reduced or even prevented. Therefore, a photodetector including a SiN waveguide with improved opto-electrical bandwidth can be realised. In particular, patterning of the SiN layer to fabricate the SiN waveguide can be performed after fabrication of the photodiode while applying the SiN layer can be carried before fabrication of the photodiode. Thereby, it is possible to realise a direct contact between the light-sensitive region and the SiN waveguide, i.e., there is no gap between these two, which may result in an improved coupling efficiency from SiN waveguide to the light sensitive region.

Another advantage of the photodetector is that parasitic capacitance can be prevented that would originate by vertically protruding offshoots made of the n-doped and p-doped material of the photodiode. Thereby, the RC time constant of the photodetector can be reduced in comparison to known device concepts resulting in turn in an improved opto-electrical bandwidth of the photodiode.

As the light-sensitive region serves to provide an optically active region, e.g., for detecting photons by the photoelectric effect, and is sandwiched laterally between the p-doped and n-doped contact regions of which, preferably, one or both are made of another material, photo carrier generation in the doped regions can be reduced compared to a diode in which the doped and intrinsic regions are made of the same material of the optically active region. The photo carriers may be generated essentially in the intrinsic region such that the photo carriers are influenced by the electric field provided between the doped regions. Photo carriers in doped regions may only diffuse, i.e., they move slowly, compared to the photo carriers influenced by the electric field. As a result, the diode according to the invention may provide a larger opto-electrical bandwidth, which allows providing faster receivers.

The light-sensitive intrinsic region sandwiched laterally between the p-doped contact region and the n-doped contact region in a direction transverse to a direction of light propagation in the SiN waveguide is obtainable by sequentially providing the p-doped region in-situ doped and the n-doped region in-situ doped such that the intrinsic region has a maximal lateral extension between two lateral ends of the intrinsic region of equal to or below 300 nm, preferably equal to or below 200 nm, more preferably equal to or below 150 nm, and such that the intrinsic region is substantially not unintentionally doped when producing the diode.

It is particularly preferred that a lateral width of the SiN waveguide along the lateral stacking direction exceeds the lateral width of light-sensitive region on both sides by at least 20 nm, preferably, by at least 50 nm. In particular, it is preferred that the lateral width of the SiN waveguide is by up to 50 nm larger than the lateral width of the photodiode. It may be even beneficial for some applications if the lateral width of the SiN waveguide is by up to 100 nm larger than the lateral width of the photodiode.

In particular, in a photodetector comprising a photodiode with laterally protruding p-doped and n-doped edge portions, it is preferred, that a height of the laterally protruding p-doped edge portion and/or laterally protruding n-doped edge portion along the vertical stacking direction is equal to or smaller than a height of the light sensitive region along the vertical stacking direction. Thereby, the parasitic capacitance originated by the protruding vertical offshoots as present in the some known devices can be prevented, which may be beneficial for the RC time constant and thus the opto-electrical bandwidths of the photodiode. Preferably, the SiN waveguide is in contact with at least a part of the laterally protruding p-doped edge portion and/or at least a part of the laterally protruding n-doped edge portion.

In the semiconductor structure, it is thus preferred that the lateral Ge photodiode is directly coupled to a Si waveguide arranged in the semiconductor wafer. Accordingly, preferably, the photodetector comprises a Si waveguide that comprises Si and that is arranged below the photodiode along the stacking direction forming a common lower interface with the photodiode at which the Si waveguide is in direct contact with at least a part of the light sensitive region. For example, the photodiode may have a lower coupling surface that is opposite to an upper coupling surface and wherein the photodetector comprises a Si waveguide that comprises Si and that is coupled to the photodiode on its lower coupling surface and in direct contact with at least a part of the light sensitive region. Thereby, a double waveguide connection can be realised. The Si waveguide and the SiN waveguide may be arranged in different photonic planes of a photonic intergraded circuit. Preferably, the Si waveguide has a width along the lateral stacking direction that is equal to or larger than a lateral width of the photodiode.

Preferably, the semiconductor structure comprises a wafer-to-wafer bonding enhancement layer that is arranged to form the wafer-to-wafer bonding interface with the first of the interconnect layer pairs. The wafer-to-wafer bonding enhancement layer can be made of a comparatively reactive material such as AIO and preferably has a thickness of 10 nm to 50 nm. When using a wafer-to-wafer bonding enhancement layer, a comparatively strong bond at the wafer bonding interface can be achieved.

The present invention also relates to a method of fabricating a semiconductor structure, the method comprising the steps of
- providing a semiconductor wafer and a photonic integrated circuit or an electronic-photonic integrated circuit, hereinafter commonly referred to as integrated circuit, on the semiconductor wafer, and
- fabricating a FEOL section of the integrated circuit,
- fabricating a BEOL section of the integrated circuit, the BEOL section comprising interconnect layer pairs each comprising a metal interconnect layer and an interlevel dielectric layer, wherein
   fabricating the BEOL section comprises bonding a first of the interconnect layer pairs and a second of the interconnect layer pairs that is arranged closer to the FEOL section than the first interconnect layer pair together via wafer-to-wafer bonding, or wherein
   fabricating the BEOL section comprises bonding a first of the interconnect layer pairs to the FEOL section such that a wafer-to-wafer bonding interface is formed between the first of the interconnect layer pairs and the FEOL section, and
   wherein the first interconnect layer pair comprises at least one SiN waveguide.

The method allows for the integration of ultra-low loss SiN waveguides in the BEOL of standard silicon technologies. By the integration of LPCVD-SiN in the BEOL section of standard silicon technologies, it is possible to enable low loss waveguides in a wide optical range from visible to mid infrared wavelengths. In case, in addition, a local backside etch is employed, substrate losses can be further reduced. Moreover, at the same time a coupling to fast Ge photodetectors is possible. Before, coupling to fast Ge photodetectors was typically not possible since, often, SiN had rather thick claddings in the range of a few micrometres below and above the SiN waveguides. As a result of this thick claddings, coupling to integrated Ge photodetectors was not possible, at least not by epitaxial deposition of Ge on SiN in a monolithic fashion.

In the method, fabricating the BEOL section may comprise
- providing the bonding wafer, the bonding wafer comprising a Si substrate, and a SiOz layer arranged on the Si substrate,
- applying a SiN layer on the SiOz layer at a temperature of 600 °C or more, preferably, of 700 °C or more,
- optionally, pre-patterning of the SiN layer,
- applying a cladding layer on the SiN layer, preferably a SiOz cladding layer,
- planarizing the SiOz cladding applied on the SiN layer,
- bonding the bonding wafer with its planarized SiOz cladding to an interconnect layer pair or the FEOL section by means of wafer-to-wafer bonding such that a wafer-to-wafer bonding interface is formed between the bonding wafer and the interconnect layer pair, and
- removing the Si substrate from the bonding wafer.

Pre-patterning may comprise partial, rough structuring of the one or more SiN layers and may be advantages to achieve stress relief. A planar and smooth surface of the cladding layer is advantageous to restore a suitable surface for wafer-to-wafer bonding. A SiOz cladding layer is preferred since the process integration into standard BEOL processing is particularly easy. However, it is possible to use another cladding material, in particular if the expense of higher processing cost is justified by improved coupling efficiency or reduced material cost.

Subsequent planarization can be achieved by chemical-mechanical polishing (CMP) and may provide a planar surface for standard BEOL-processes. Standard BEOL-processes may include the fabrication of contact-tungsten plugs, a first metal layer and so on.

The method may further comprise
- patterning of the SiN layer to fabricate the at least one SiN waveguide of the first interconnect layer pair, and
- BEOL processing of the first interconnect layer pair.

Patterning of the SiN layer and in particular fine patterning, preferably, is to be performed after bonding to the semiconductor wafer, which enables patterning with lithographic accuracy of the SiN layer, i.e., for fabricating at least one SiN waveguide with sharp overlay to the structures of the first wafer. Prior to patterning of the SiN layer, the bonding wafer may be removed from the semiconductor wafer.

Since LPCVD SiN is deposited on a separate, bonding wafer, it is possible that a single or even multiple SiN layers are realized. Thus, SiN waveguides with low and high optical confinement could be realized at the same time by a thinner (<100 nm) SiN layer and a thicker SiN layer (>400 nm). By patterning of the SiN layer with high precision having lithographic accuracy, it is possible to fabricate the SiN waveguide as a rib waveguide, a ridge or wire waveguide, a diffused waveguide, a strip-loaded waveguide, or a slot waveguide.

The present invention also relates to a use of the semiconductor structure described above in optical networking or in a telecommunication network, preferably, employing electromagnetic radiation in the wavelength range of 0.8 µm to 1.65 µm.

It shall be understood that the semiconductor structure of claim 1 and the method of claim 12 have similar and/or identical preferred embodiments, in particular, as defined in the dependent claims.

It shall be understood that a preferred embodiment of the present invention can also be any combination of the dependent claims or above embodiments with the respective independent claim.

These and other aspects of the invention will be apparent from and elucidated with reference to the embodiments described hereinafter.

### BRIEF DESCRIPTION OF THE DRAWINGS

In the following drawings:
Fig. 1: schematically and exemplary shows a semiconductor structure with a first of the interconnect layer pairs of a BEOL section being wafer-to-wafer bonded to a FEOL section of an integrated circuit;
Fig. 2: schematically and exemplary shows a semiconductor structure with a first of the interconnect layer pairs of a BEOL section being wafer-to-wafer bonded to a second of the interconnect layer pairs that is arranged closer to the FEOL section than the first interconnect layer pair; and
Figs. 3 to 9: schematically and exemplary show several different intermediate products that are fabricated when conducting a method for fabricating a semiconductor structure by bonding a bonding wafer to a semiconductor wafer.

### DETAILED DESCRIPTION OF EMBODIMENTS

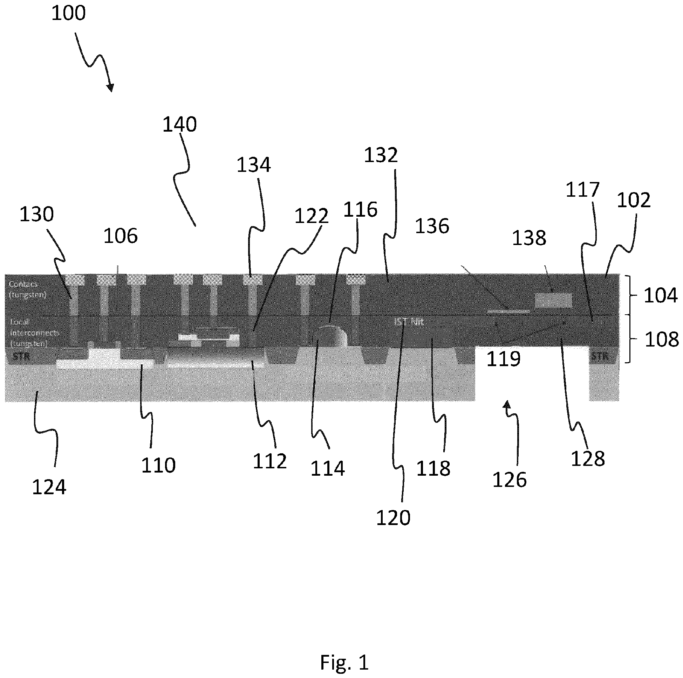

Figure 1 schematically and exemplary shows a semiconductor structure 100 with a first interconnect layer pair 102 of a BEOL section 104 being wafer-to-wafer bonded at a wafer-to-wafer bonding interface 106 to a FEOL section 108 of an integrated circuit.

Only exemplary, the FEOL section 108 comprises a CMOS transistor 110, a SiGe:C heterojunction bipolar transistor (HBT) 112, a lateral Ge photodiode 114 (shown in cross-section) directly coupled to a SiN waveguide 116, and a further lateral Ge photodiode 118 (shown in longitudinal section) directly coupled to an IST-nitride waveguide 120. Furthermore, a further SiN waveguide 117 is provided in the FEOL section 108. Moreover, the FEOL section 108 comprises a plurality of local interconnects 122 that are made of tungsten. The local interconnects 122 are embedded in a dielectric material such as SiOz.

The FEOL section 108 is thus fabricated up to a first tungsten contact module. On top of the FEOL section 108, there is a planar and smooth surface, well suited for wafer-to-wafer bonding. The FEOL section 108 is arranged on a semiconductor wafer 124 that comprises Si. In the semiconductor wafer 124 there is a local backside etch 126 where the material 128 of the semiconductor wafer 124 was removed.

On top of the planar and smooth surface of the FEOL section 108, the BEOL section 104 is arranged. The BEOL section 104 comprises the first interconnect layer pair 102 that is bonded at the wafer-to-wafer bonding interface 106 directly to the FEOL section 108. The first interconnect layer pair 102 comprises an interlevel dielectric layer 132 accommodating several tungsten contacts 130. Furthermore, the first interconnect layer pair 102 comprises a metal interconnect layer 134.

In addition, the first interconnect layer pair 102 and thus the BEOL section 104 comprises a low-confinement SiN waveguide 136 and a high-confinement SiN waveguide 138 that are coupled via interlayer coupling 119 to the IST-nitride waveguide 120 and the further SiN waveguide 117 in the FEOL section 108. To reduce substrate losses originating from the semiconductor wafer 124, the local backside etch 126 is located opposite the low-confinement SiN waveguide 136 and the high-confinement SiN waveguide 138.

The BEOL section 104 may continue with further interconnect layer pairs that are fabricated as known in the art as indicated by a vertically pointing arrow 140.

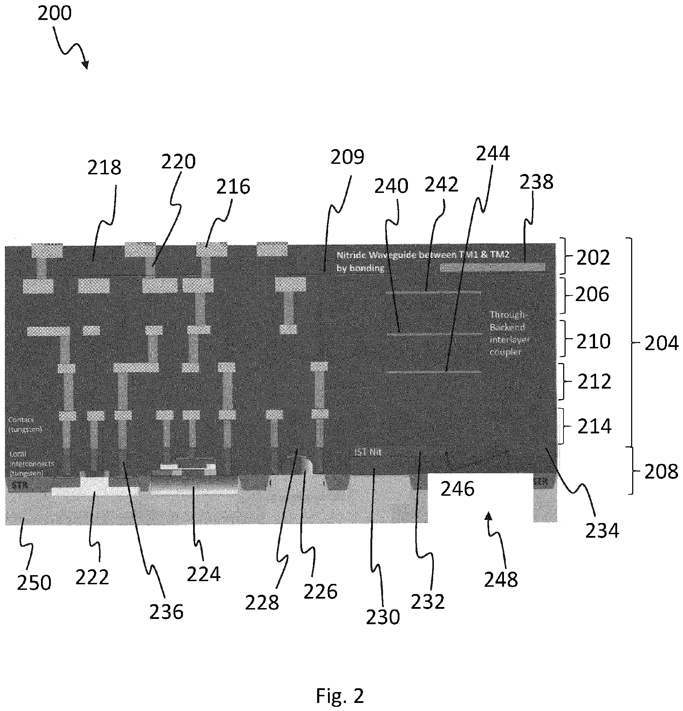

Figure 2 schematically and exemplary shows a semiconductor structure 200 with a first interconnect layer pair 202 of a BEOL section 204 being wafer-to-wafer bonded to a second of the interconnect layer pairs 206 that is arranged closer to an FEOL section 208 than the first interconnect layer pair 202. Accordingly, a wafer-to-wafer bonding interface 209 is present between the first interconnect layer pair 202 and the second interconnect layer pairs 206.

The BEOL section 204 comprises further interconnect layer pairs 210, 212, 214 that each have a respective metal interconnect layer and an interlevel dielectric layer. The first interconnect layer pair 202 likewise comprises a metal interconnect layer 216 and an interlevel dielectric layer 218. Moreover, tungsten contacts 220 are embedded in the interlevel dielectric layer 218 that connect the metal interconnect layer 216 with electrooptical devices present in the FEOL section 208. As the semiconductor stricture 100 described with reference to figure 1, also FEOL section 208 comprises a CMOS transistor 222, a SiGe:C HBT 224, a lateral Ge photodiode 226 (shown in cross-section) directly coupled to a SiN waveguide 228, and a further lateral Ge photodiode 230 (shown in longitudinal section) directly coupled to an IST-nitride waveguide 232. Furthermore, another SiN waveguide 234 is provided in the FEOL section 208. Moreover, the FEOL section 208 comprises a plurality of vias 236 that are made of tungsten. The local interconnects 236 are embedded in a dielectric material such as SiOz.

The first interconnect layer pair 202 comprises a SiN waveguide 238 that is coupled via several though-backend interlayer couplers 240, 242, 244 to the IST-nitride waveguide 232 in the FEOL section 208. The IST-nitride waveguide 232 is coupled via interlayer coupling 246 to the further SiN waveguide 234. Opposite the SiN waveguide 238 of the first interconnect layer pair 202, there is a local backside etch 248 in the semiconductor wafer 250 to reduce substrate losses in the SiN waveguide 238.

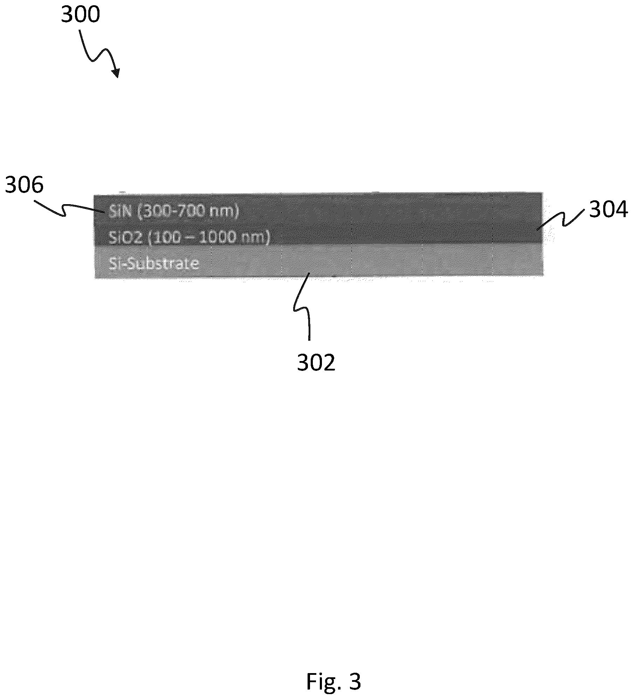

Figures 3 to 9 schematically and exemplary show several different intermediate products that are fabricated when conducting a method for fabricating a semiconductor structure by bonding a bonding wafer to a semiconductor wafer.

Figure 3 shows a first intermediate product 300 comprising a high confinement SiN layer on a SiOz layer on a Si wafer. In particular, the first intermediate product 300 is a bonding wafer comprising a Si substrate 302, a SiOz layer 304 on top of the silicon substrate 302 and a SiN layer 306 on top of the SiOz layer 304. The SiOz layer 304 can have a thickness of 100 nm to 1000 nm. The SiN layer 306 can have a thickness of 300 nm to 700 nm.

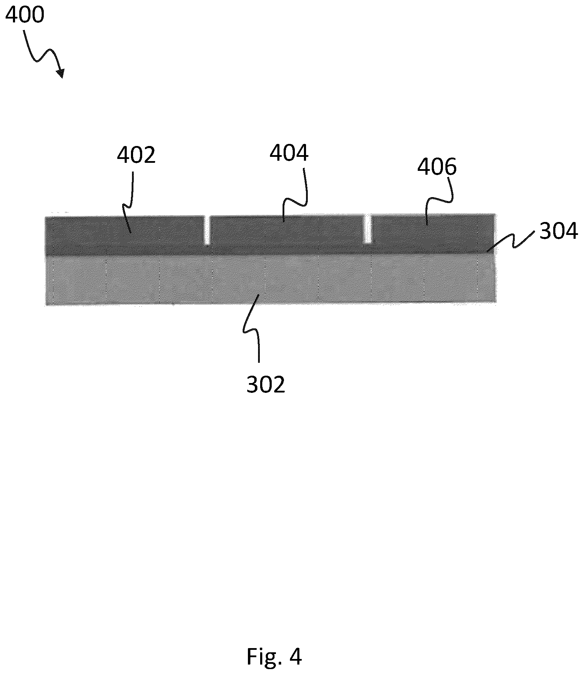

Figure 4 shows a second intermediate product 400 that is obtained after pre-patterning of the first intermediate product 300. As a result of the pre-patterning, the SiN layer 306 is separated into several pieces 402, 404, 406, e.g., using chemical etching, to reduce stress, in particular, wafer bow.

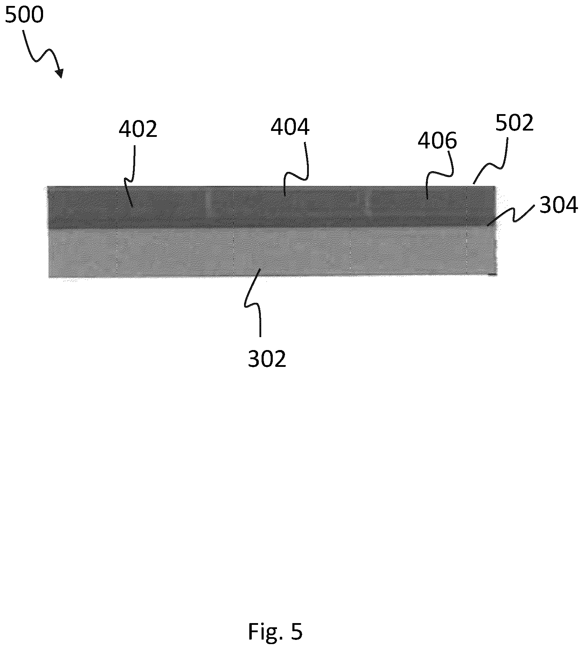

Figure 5 shows a third intermediate product 500 that is obtained after providing a cladding layer 502 onto the second intermediate product 400 and subsequent planarization. Planarization can be achieved using CMP.

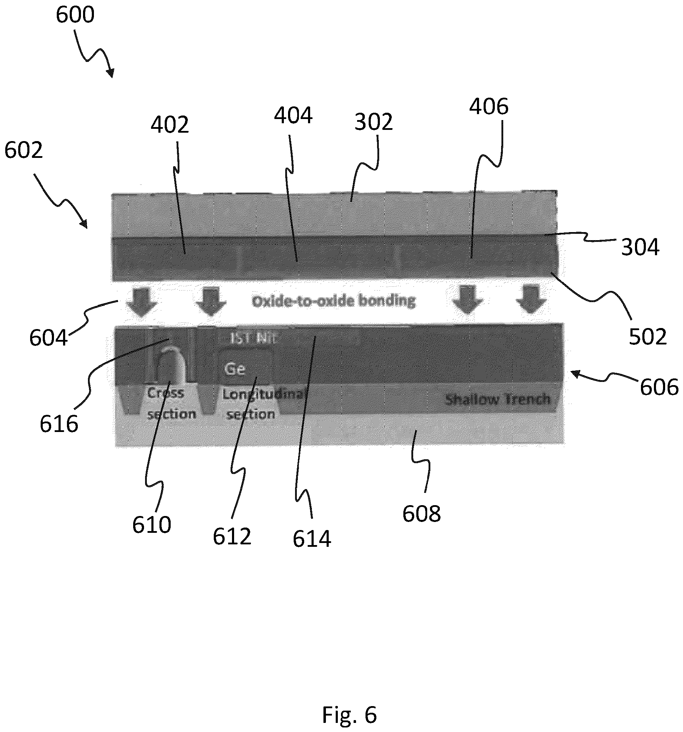

Figure 6 shows a fourth intermediate product 600 that is obtained by flipping the bonding wafer 602 and bonding the bonding wafer 602 using oxide-to-oxide bonding 604 to a FEOL section 606 arranged on a semiconductor wafer 608 comprising a Ge photodiode 610 shown in cross section and a Ge photodiode 612 shown in longitudinal section. The Ge photodiodes 610, 612 each are directly coupled to an IST-nitride waveguide 614, 616, respectively.

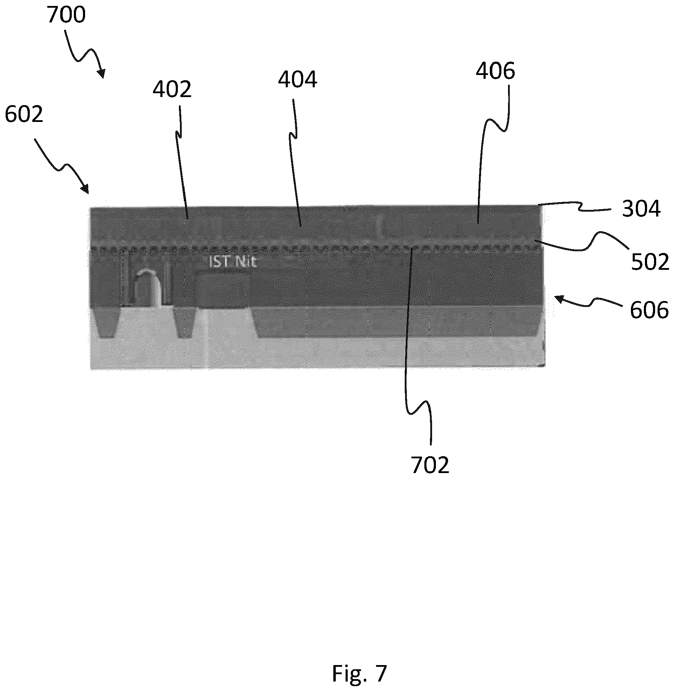

Figure 7 shows a fifth intermediate product 700 that is obtained by removing the Si substrate 302 from the bonding wafer 602 of the fourth intermediate product 600, e.g., by grinding and/or reactive ion etching (RIE). As can be seen in the fifth embodiment 700, a wafer-to-wafer bonding interface 702 is present between the remaining layers of the bonding wafer 602, i.e., the cladding layer 502, the pieces 402, 404, 406 of the SiN layer 306 and the SiOz layer 304, and the FEOL section 606.

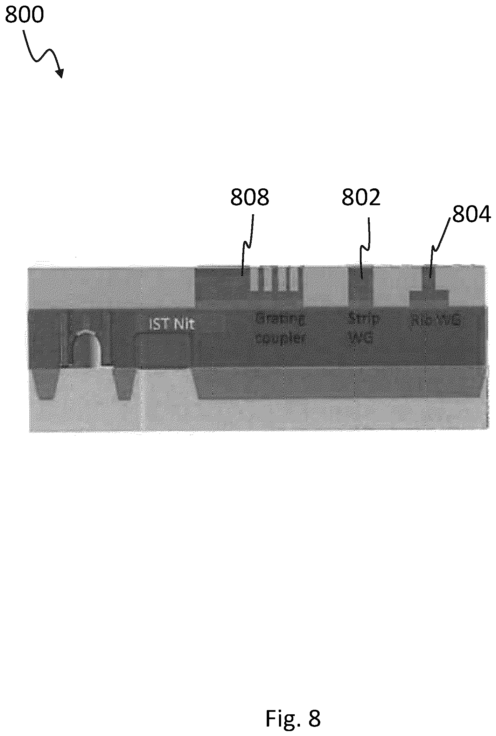

Figure 8 shows a sixth intermediate product 800 that is obtained by fine-patterning of the pieces 402, 404, 406 of the SiN layer 306 with lithographic precision to enable coupling to IST-nitride to form waveguides, here an exemplary strip waveguide 802 and an exemplary rib waveguide 804, as well as a grating coupler 806, and subsequent oxide cladding and CMP.

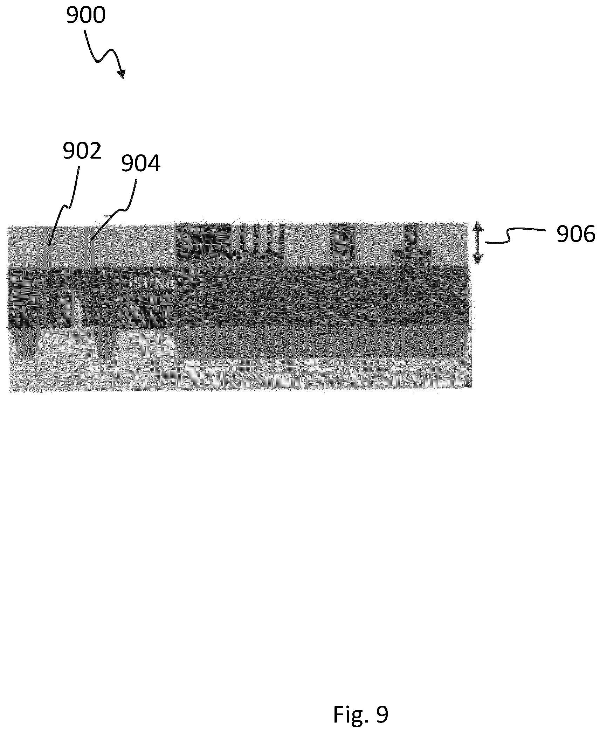

Figure 9 shows a seventh intermediate product 900 that is obtained by BEOL processing of the sixth intermediate product 800. Only exemplary, contact plugs 902, 904 are shown in the seventh intermediate product 900. The thickness 906 of the first interconnect layer pair is between 500 nm and 1000 nm, e.g., 650 nm.

Other variations to the disclosed embodiments can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality.

Any reference signs in the claims should not be construed as limiting the scope.

## Claims

1. A semiconductor structure comprising:
- a semiconductor wafer and a photonic integrated circuit or an electronic-photonic integrated circuit, hereinafter commonly referred to as integrated circuit, on the semiconductor wafer, wherein
- the integrated circuit comprises a front-end-of-line section, hereinafter FEOL section, and comprises a back-end-of-line section, hereinafter BEOL section, with interconnect layer pairs each comprising a metal interconnect layer and an interlevel dielectric layer, and wherein
a wafer-to-wafer bonding interface is formed between a first of the interconnect layer pairs and a second of the interconnect layer pairs, the second of the interconnect layer pairs is arranged closer to the FEOL section than the first interconnect layer pair, or
a wafer-to-wafer bonding interface is formed between the first of the interconnect layer pairs and the FEOL section, wherein
the first interconnect layer pair comprises at least one SiN waveguide.

2. The semiconductor structure according to claim 1, wherein the first interconnect layer pair is embedded between further interconnect layer pairs of the BEOL section.

3. The semiconductor structure according to at least one of the preceding claims, wherein the first interconnect layer pair comprises at least two SiN waveguides that each are located at a different distance from the integrated circuit.

4. The semiconductor structure according to at least one of the preceding claims, wherein the at least one SiN waveguide of the first interconnect layer pair is evanescently coupled to a further SiN waveguide.

5. The semiconductor structure according to claim 4, wherein the further SiN waveguide is located in the FEOL section.

6. The semiconductor structure according to at least one of the preceding claims, wherein the at least one SiN waveguide of the first interconnect layer pair is configured to guide electromagnetic radiation at a wavelength of 850 nm or more with a loss of below or no more than 1 db per cm.

7. The semiconductor structure according to at least one of the preceding claims, wherein the semiconductor wafer comprises a local backside etch at a position opposite the at least one SiN waveguide of the first interconnect layer pair.

8. The semiconductor structure according to at least one of the preceding claims, wherein at least one interconnect layer pair includes a though-backend interlayer coupler that is arranged and configured for coupling electromagnetic radiation out of or into the at least one SiN waveguide of the first interconnect layer pair.

9. The semiconductor structure according to at least one of the preceding claims, wherein the FEOL section comprises a lateral Ge photodiode, the lateral Ge photodiode being evanescently coupled to the at least one SiN waveguide of the first interconnect layer pair.

10. The semiconductor structure according to claim 9, wherein the lateral Ge photodiode is directly coupled to a Si waveguide arranged in the semiconductor wafer.

11. The semiconductor structure according to at least one of the preceding claims, comprising a wafer-to-wafer bonding enhancement layer that is arranged to form the wafer-to-wafer bonding interface with the first of the interconnect layer pairs.

12. A method of fabricating a semiconductor structure, the method comprising the steps of
- providing a semiconductor wafer and a photonic integrated circuit or an electronic-photonic integrated circuit, hereinafter commonly referred to as integrated circuit, on the semiconductor wafer, and
- fabricating a FEOL section of the integrated circuit,
- fabricating a BEOL section of the integrated circuit, the BEOL section comprising interconnect layer pairs each comprising a metal interconnect layer and an interlevel dielectric layer, wherein
fabricating the BEOL section comprises bonding a first of the interconnect layer pairs and a second of the interconnect layer pairs that is arranged closer to the FEOL section than the first interconnect layer pair together via a wafer-to-wafer bonding, or wherein
fabricating the BEOL section comprises bonding a first of the interconnect layer pairs to the FEOL section such that a wafer-to-wafer bonding interface is formed between the first of the interconnect layer pairs and the FEOL section, and wherein
the first interconnect layer pair comprises at least one SiN waveguide.

13. The method according to claim 12, wherein fabricating the BEOL section comprises
- providing the bonding wafer, the bonding wafer comprising a Si substrate, and a SiOz layer arranged on the Si substrate,
- applying a SiN layer on the SiOz layer at a temperature of 600 °C or more, preferably, of 700 °C or more,
- optionally, pre-patterning of the SiN layer,
- applying a SiOz cladding on the SiN layer,
- planarizing the SiOz cladding applied on the SiN layer,
- bonding the bonding wafer with its planarized SiOz cladding to an interconnect layer pair or the FEOL section by means of wafer-to-wafer bonding such that a wafer-to-wafer bonding interface is formed between the bonding wafer and the interconnect layer pair, and
- removing the Si substrate from the bonding wafer.

14. The method according to claim 13, comprising
- patterning of the SiN layer to fabricate the at least one SiN waveguide of the first interconnect layer pair, and
- BEOL processing of the first interconnect layer pair.

15. A use of the semiconductor structure according to at least one of claims 1 to 11 in optical networking or in a telecommunication network.
